# EUROPÄISCHE PATENTSCHRIFT

(11) **EP 0 797 103 B1**
(45) Veröffentlichungstag und Bekanntmachung des Hinweises auf die Patenterteilung: **02.06.1999**
(21) Anmeldenummer: 97103660.3
(22) Anmeldetag: 05.03.1997
(51) Int. Cl.: G01R 33/38

(54) **Magnetanordnung für die bildgebende magnetische Resonanz mit zwei getrennten Abbildungsvolumina**
MPI magnet assembly with two separated imaging volumes
Assemblage d'aimants pour IRM avec deux volumes à imager separés

(30) Priorität: 28.03.1996 DE 19612421
(43) Veröffentlichungstag der Anmeldung: 24.09.1997
(73) Patentinhaber: SIEMENS AKTIENGESELLSCHAFT, 80333 München (DE)
(72) Erfinder: Frese, Georg, Dipl.-Phys., 91074 Herzogenaurach (DE); Siebold, Horst, Dr., 91090 Effeltrich (DE)

(56) Entgegenhaltungen:
- EP-A- 0 400 922
- EP-A- 0 766 094
- WO-A-90/05369
- US-A- 5 389 879

## Beschreibung

Die Erfindung betrifft eine Magnetanordnung für ein diagnostisches Magnetresonanzgerät mit ersten Mitteln zum Erzeugen eines Magnetfeldes in einem ersten Abbildungsvolumen, wobei das erste Abbildungsvolumen innerhalb der ersten Mittel angeordnet ist.

Eine Magnetanordnung der eingangs genannten Art ist aus dem US-Patent 5 365 927 bekannt. Einleitend ist dort eine klassische supraleitende Magnetanordnung skizziert, die eine zylinderförmige Patientenröhre umgibt. Der supraleitende Magnet erzeugt im Inneren der Patientenröhre ein homogenes und zeitlich konstantes Hauptmagnetfeld in einem annähernd kugelförmigen Abbildungsvolumen. Typischerweise liegt der Durchmesser des Abbildungsvolumens im Bereich von 50 cm. Der Zugang zum Abbildungsvolumen beschränkt sich auf die stirnseitigen Öffnungen in der Patientenröhre. Durch Magnetresonanzbiidgebung (MRI) unterstützte interventionelle Techniken, wie z.B. chirurgische Eingriffe am Patienten, lassen sich jedoch nicht durchführen. Zudem besteht die Gefahr von klaustrophobischen Reaktionen des Patienten.

Dem gegenüber stehen offene Magnetsysteme, die zusätzlich zum patientenzugang einen seitlichen Zugang für einen Arzt oder Untersucher zum Abbildungsvolumen aufweisen. Ein offenes Magnetsystem ist ebenfalls in der eingangs schon zitierten US-Patentschrift 5 365 927 beschrieben. Offene Magnetsysteme haben in der Regel den Nachteil, daß ihr durch die Größe des homogenen Magnetfeldes definiertes Abbildungsvolumen gegenüber den klassischen Systemen kleiner ist. Dies führt zu einer eingeschränkten Bildgebung, insbesondere wegen eines reduzierten Signal-Rauschverhältnisses, längerer Meßzeiten, und Einschränkungen in der Anwendbarkeit von Sequenztypen. Offene Systeme sind in der Regel Niederfeldsysteme mit Hauptmagnetfeldstärken von 0,05 T bis 0,5 T, da meist größere Volumen mit Feld erfüllt werden müssen.

Aus der EP-A-0 400 922 ist ein Magnetsystem für ein Magnetresonanzgerät bekannt, das zwei axial beabstandete und verschieden aufgebaute Teilsysteme umfaßt. Die beiden Teilsysteme erzeugen in einem Abbildungs- oder Arbeitsvolumen, das zwischen den Teilsystemen liegt, ein weitgehend homogenes Magnetfeld. Der Abstand der beiden Teilsysteme zueinander kann so gewählt werden, daß quer zum Abstand ein Zugang zum Abbildungsvolumen möglich ist.

Aus der WO90/05369 ist eine Magnetanordnung bekannt, die zwei getrennte Abbildungsvolumen mit homogenem Magnetfeld aufweist. Als Mittel zum Erzeugen des Magnetfeldes ist ein supraleitender Elektromagnet vorgesehen. Zu beiden Seiten des Elektromagneten sind axial beabstandet zwei Polschuhe angeordnet, die über eine Flußrückführung miteinander verbunden sind. Zwischen dem Elektromagneten und jedem Polschuh befindet sich jeweils eins der Abbildungsvolumen. Die Abbildungsvolumen haben einen Durchmesser von jeweils ca. 26 cm.

Die US-PS 4,701,736 beschreibt ein Magnetsystem für ein Magnetresonanzgerät mit mehreren ineinander angeordneten Spulen, mit denen ein homogenes Magnetfeld in einem axial versetzten Abbildungsvolumen erzeugt werden kann.

Die EP-A-0 187 691 offenbart unsymmetrische Magnetsysteme, die ein axial versetztes Abbildungsvolumen mit einem homogenen Magnetfeld besitzen.

In der US-PS 5,389,879 ist eine Magnetanordnung beschrieben, die zwei axial beabstandete Elektromagneten umfaßt. Einer der Elektromagnete besitzt eine zylinderförmige Spule, bei der der Innendurchmesser in der Größenordnung der axialen Länge liegt. Das Abbildungsvolumen liegt zum Teil innerhalb der zylinderförmigen Spule und erstreckt sich in axialer Richtung weiter außerhalb dieser Spule zum zweiten Elektromagneten.

Der Erfindung liegt nun die Aufgabe zugrunde, eine Magnetanordnung für ein diagnostisches Magnetresonanzgerät anzugeben, die zum einen hohe Anforderungen an die Abbildungsleistung erfüllt und zum anderen interventionelle Techniken unterstützt.

Die Aufgabe wird dadurch gelöst, daß beabstandet zu den ersten Mitteln zweite Mittel zum Erzeugen eines Magnetfeldes in einem zweiten, vom ersten Abbildungsvolumen getrennten Abbildungsvolumen angeordnet sind, wobei das zweite Abbildungsvolumen zwischen den ersten Mitteln und den zweiten Mitteln angeordnet ist, und daß beide Mittel so ausgebildet sind, daß die Magnetfelder im ersten und zweiten Abbildungsvolumen, die jeweils durch Überlagerung des von den ersten Mitteln erzeugten Magnetfelds mit dem von den zweiten Mitteln erzeugten Magnetfeld zustandekommen, homogen sind. Die ersten Mittel zum Erzeugen eines homogenen Magnetfeldes in dem ersten Abbildungsvolumen besitzen eine Doppelfunktion insoweit, daß sie auch zum homogenen Magnetfeld im zweiten Abbildungsvolumen beitragen. Die erfindungsgemäße Magnetanordnung gibt die Voraussetzungen für eine uneingeschränkte Bildgebung in dem ersten, großen Abbildungsvolumen und einen weitgehend ungehinderten Zugang auch für einen Untersucher zu dem zweiten, kleinen Abbildungsvolumen. Ein auf der erfindungsgemäßen Magnetanordnung aufbauendes Magnetresonanzgerät benötigt gegenüber einem herkömmlichen Magnetresonanzgerät lediglich ein zweites Gradientenspulensystem und gegebenenfalls weitere Hochfrequenzantennen, das Meß- und Auswertesystem kann für beide Abbildungsvolumen genutzt werden. Gegebenenfalls lassen sich auch bereits installierte Systeme aufrüsten, so daß neben einem "normalen" Abbildungsvolumen auch ein für interventionelle Techniken verwendbares zweites Abbildungsvolumen zur Verfügung gestellt wird.

Die zweiten Mittel erzeugen im ersten Abbildungsvolumen einen Feldgradienten in axialer Richtung, der mit bekannten Methoden passiv oder aktiv kompensiert werden kann (passiver oder aktiver Shim). Bei einer vorteilhaften Ausgestaltung sind die Elektromagnetspulen der ersten Mittel zum Erzeugen eines homogenen Magnetfeldes ausgebildet, jeweils eine Durchflutung zu erzeugen, die mit zunehmendem Abstand der Elektromagnetspulen vom zweiten Abbildungsvolumen größer wird. Die Durchflutung kann zum einen durch eine Variation der Windungszahlen der Elektromagnetspulen, zum anderen auch über die Erregung mit verschieden hohen Strömen realisiert werden.

Bei einer weiteren vorteilhaften Ausgestaltung ist eine Patientenliege in das erste oder zweite Abbildungsvolumen verschiebbar angeordnet.

Weitere vorteilhafte Ausgestaltungen sind durch die Unteransprüche gekennzeichnet.

Die Erfindung wird im folgenden anhand von zwei Figuren erläutert. Es zeigen:
- FIG 1: in einer Schnittdarstellung eine Magnetanordnung mit zwei Abbildungsvolumen und
- FIG 2: eine Variante der Magnetanordnung nach FIG 1 in einer perspektivischen Darstellung.

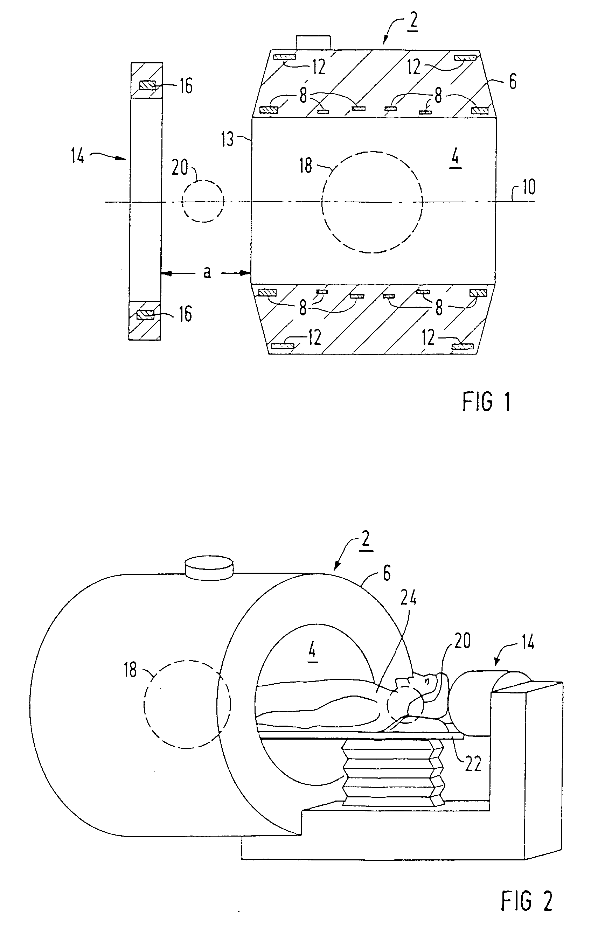

FIG 1 zeigt in einer Schnittdarstellung eine Seitenansicht einer Magnetanordnung für ein diagnostisches Magnetresonanzgerät. Ein erstes Magnetsystem 2 entspricht in seinem Aufbau einem herkömmlichen supraleitenden Magneten mit einem zylinderförmig ausgebildeten Innenraum 4. Beispielsweise besitzt der Innenraum 4 einen lichten Durchmesser von ca. 1 m und einer Länge von ca. 1,40 m. In den Innenraum 4 werden hier nicht dargestellte Gradientenspulen, Hochfrequenzantennen und Patientenlagerungseinrichtungen eingebaut. Das erste Magnetsystem 2 umfaßt in einem Kryostaten 6 angeordnete kreisringförmige Elektromagnetspulen 8, deren Spulenachsen auf einer Symmetrieachse 10 der Magnetanordnung liegen. Zur teilweisen Abschirmung des von den Elektromagnetspulen 8 erzeugten Magnetfeldes im Außenraum des Magnetsystems 2 ist eine aktive Schirmung in Form von Schirmspulen 12 vorgesehen. Hier sind zwei Schirmspulen 12 auf einem im Vergleich zu den Elektromagnetspulen 8 größeren Radius angeordnet, die Spulenachse der Schirmspulen 12 liegt ebenfalls auf der Symmetrieachse 10 des Magnetsystems 2.

In einem Abstand a von ca. 50 cm bis 60 cm von einer Stirnseite 13 des Magnetsystems 2 ist ein zweites Magnetsystem 14 mit einer kreisringförmigen Elektromagnetspule 16 angeordnet. Der Mittelpunkt der Elektromagnetspule 16 liegt ebenfalls auf der Symmetrieachse 10. Patientenzugangsrichtungen sind vorzugsweise parallel zur Symmetrieachse 10 ausgerichtet.

Die Magnetspulen 8,12,16 sind mit hier nicht dargestellten Stromversorgungen verbunden, die die zum Aufbau der Magnetfelder benötigten Ströme liefern. Dabei fließen die Ströme in den Elektromagnetspulen 8 und 16 gleichsinnig um die Achse 10, während die Ströme in der Elektromagnetspule 12 in entgegengesetzter Richtung fließen.

Ein von dem zweiten Magnetsystem 14 erzeugter störender Feldgradient im Innenraum 4 des ersten Magnetsystems 2 in axialer Richtung wird hier durch eine entsprechende Dimensionierung und Erregung der Elektromagnetspulen 8 kompensiert. Dabei sind diejenigen axialen Positionen der Elektromagnetspulen 8 beibehalten, die sie im ersten Magnetsystem 2 hätten, wenn kein zweites Magnetsystem 14 vorhanden wäre. Die Kompensation des Feldgradienten erfolgt derart, daß von den Elektromagnetspulen 8 jeweils erzeugte Durchflutungen mit zunehmenden axialen Abstand der Elektromagnetspulen 8 von dem zweiten Magnetsystem 14 zunehmen. Bei gleichem Erregungsstrom durch alle Elektromagnetspulen 8 steigt somit die Windungszahl der einzelnen Elektromagnetspulen 8 mit zunehmenden axialen Abstand vom zweiten Magnetsystem 14. Die Magnetanordnung kann dann in einem ersten, größeren Abbildungsvolumen 18 und in einem zweiten, kleineren Abbildungsvolumen 20 jeweils ein homogenes Magnetfeld erzeugen. Das erste Abbildungsvolumen 18 befindet sich wie bei einem herkömmlichen supraleitenden Magnetsystem im Innenraum 4, während das zweite Abbildungsvolumen zwischen den beiden Magnetsystemen 2,14 angeordnet ist und zusätzlich seitlich frei zugänglich ist. Die Richtung des homogenen Magnetfeldes ist in den beiden Abbildungsvolumen 18,20 gleich und parallel zur Symmetrieachse 10. Die Feldstärke ist im ersten Abbildungsvolumen 18 größer als im zweiten Abbildungsvolumen 20.

FIG 2 zeigt in einer perspektivischen Ansicht ein Magnetresonanzgerät auf der Basis einer weiteren Ausführung der erfindungsgemäßen Magnetanordnung, mit der homogene Magnetfelder in zwei getrennten Abbildungsvolumen 18,20 erzeugt werden können. Das zweite Magnetsystem 14 ist als Polschuh ausgeführt, der einen im Vergleich zur in FIG 1 dargestellten Ausführung verbesserten Zugang zum zweiten Abbildungsvolumen 20 bietet. Die Polschuhanordnung 14 umfaßt als magnetische Antriebe vorzugsweise Permanentmagnete. Mit einer verschiebbaren Patientenliege 22 kann ein zu untersuchender oder zu behandelnder Patient 24 sowohl im ersten Abbildungsvolumen 18 als auch ohne weitere Umlagerung im zweiten Abbildungsvolumen 20 zur Bilderstellung positioniert werden.

Die in FIG 2 dargestellte Magnetanordnung mit der Polschuhausführung des zweiten Magnetsystems 14 eignet sich insbesondere für MRI-gefuhrte Eingriffe im Kopf- oder Fußbereich des Patienten 24. Dagegen erlaubt die in FIG 1 dargestellte Ausführung der Magnetanordnung auch MRI-geführte Eingriffe im mittleren Bereich des Patienten 24, weil dort das zweite Magnetsystem 14 keine Begrenzung für den Patienten in axialer Richtung darstellt.

Als Gradientenspulen zur Erzeugung der zur Ortsauflösung benötigten transversalen Gradientenfelder im zweiten Abbildungsvolumen 20 eignen sich wegen des flachen Aufbaus besonders die aus dem US-Patent 5 198 769 bekannten Segmentspulen. Das Gradientenfeld in axialer Richtung kann wie in herkömmlichen Geräten durch zwei axial beabstandete Spulen mit kreisringförmigen Windungen erzeugt werden.

## Patentansprüche

1. Magnetanordnung für ein diagnostisches Magnetresonanzgerät mit ersten Mitteln (2) zum Erzeugen eines Magnetfeldes in einem ersten Abbildungsvolumen (18), wobei das erste Abbildungsvolumen (18) innerhalb der ersten Mittel (2) angeordnet ist,
**dadurch gekennzeichnet,**
daß beabstandet zu den ersten Mitteln (2) zweite Mittel (14) zum Erzeugen eines Magnetfeldes in einem zweiten vom ersten Abbildungsverfahren (18) getrennten Abbildungsvolumen (20) angeordnet sind, wobei das zweite Abbildungsvolumen (20) zwischen den ersten Mitteln (2) und den zweiten Mitteln (14) angeordnet ist, und daß beide Mittel (2, 14) so ausgebildet sind, daß die Magnetfelder im ersten und zweiten Abbildungsvolumen (18 bzw. 20), die jeweils durch Überlagerung des von den ersten Mitteln erzeugten Magnetfelds mit dem von den zweiten Mitteln erzeugten Magnetfeld zustandekommen, homogen sind.

2. Magnetanordnung nach Anspruch 1, **dadurch gekennzeichnet**, daß die ersten und zweiten Mittel (2 bzw. 14) entlang einer Achse (10) angeordnet sind.

3. Magnetanordnung nach Anspruch 2, **dadurch gekennzeichnet**, daß das erste und zweite Abbildungsvolumen (18 und 20) entlang der Achse (10) angeordnet sind.

4. Magnetanordnung nach einem der Ansprüche 1 bis 3, **dadurch gekennzeichnet**, daß die ersten und zweiten Mittel (2 bzw. 14) ausgebildet sind, das homogene Magnetfeld in den beiden Abbildungsvolumen (18 und 20) gleich ausgerichtet zu erzeugen.

5. Magnetanordnung nach einem der Ansprüche 2 bis 4, **dadurch gekennzeichnet**, daß die ersten und zweiten Mittel (2 bzw. 14) ausgebildet sind, das homogene Magnetfeld in den beiden Abbildungsvolumen (18 und 20) parallel zur Achse (10) ausgerichtet zu erzeugen.

6. Magnetanordnung nach einem der Ansprüche 2 bis 5, **dadurch gekennzeichnet**, daß die ersten Mittel (2) mehrere, in Reihe angeordnete Elektromagnetspulen (8) mit Spulenachsen umfassen und daß die Spulenachsen und die Achse (10) deckungsgleich angeordnet sind.

7. Magnetanordnung nach Anspruch 6, **dadurch gekennzeichnet**, daß die Elektromagnetspulen (8) ausgebildet sind, jeweils eine Durchflutung zu erzeugen, wobei die Durchflutung der Elektromagnetspulen mit zunehmendem Abstand der Elektromagnetspulen (8) vom zweiten Abbildungsvolumen größer wird.

8. Magnetanordnung nach Anspruch 6 oder 7, **dadurch gekennzeichnet**, daß die Elektromagnetspulen als supraleitende Magnete in einem Kryostaten (6) angeordnet sind.

9. Magnetanordnung nach einem der Ansprüche 1 bis 8, **dadurch gekennzeichnet**, daß die zweiten Mittel (14) eine Elektromagnetspule (16) umfassen.

10. Magnetanordnung nach einem der Ansprüche 1 bis 8, **dadurch gekennzeichnet**, daß die zweiten Mittel Permanentmagnete umfassen.

11. Magnetanordnung nach einem der Ansprüche 1 bis 10, **dadurch gekennzeichnet**, daß eine Patientenliege (22) in das erste oder zweite Abbildungsvolumen (18 bis 20) verschiebbar angeordnet ist.

## Claims

1. Magnet arrangement for a diagnostic magnetic resonance apparatus having first means (2) for generating a magnetic field in a first imaging volume (18), with the first imaging volume (18) being arranged inside the first means (2), characterised in that arranged at a distance from the first means (2) are second means (14) for generating a magnetic field in a second imaging volume (20) which is separated from the first imaging volume (18), with the second imaging volume (20) being arranged between the first means (2) and the second means (14), and in that both means (2, 14) are constructed in such a way that the magnetic fields in the first and second imaging volumes (18 and 20 respectively), which each come into being as a result of superposition of the magnetic field generated by the first means with the magnetic field generated by the second means, are uniform.

2. Magnet arrangement according to claim 1,
characterised in that the first and second means (2 and 14 respectively) are arranged along one axis (10).

3. Magnet arrangement according to claim 2,
characterised in that the first and second imaging volumes (18 and 20) are arranged along the axis (10).

4. Magnet arrangement according to one of the claims 1 to 3, characterised in that the first and second means (2 and 14 respectively) are constructed so as to generate the uniform magnetic field in the two imaging volumes (18 and 20) in the same direction.

5. Magnet arrangement according to one of the claims 2 to 4, characterised in that the first and second means (2 and 14 respectively) are constructed so as to generate the uniform magnetic field in the two imaging volumes (18 and 20) in parallel with the axis (10).

6. Magnet arrangement according to one of the claims 2 to 5, characterised in that the first means (2) comprise a plurality of electromagnetic coils (8) arranged in series and having coil axes, and in that the coil axes and the axis (10) are arranged so as to coincide.

7. Magnet arrangement according to claim 6,
characterised in that the electromagnetic coils (8) are constructed so as to generate respective ampere-windings, with the ampere-windings of the electromagnetic coils increasing with increasing distance of the electromagnetic coils (8) from the second imaging volume.

8. Magnet arrangement according to claim 6 or 7, characterised in that the electromagnetic coils are arranged as superconducting magnets in a cryostat (6).

9. Magnet arrangement according to one of the claims 1 to 8, characterised in that the second means (14) comprise an electromagnetic coil (16).

10. Magnet arrangement according to one of the claims 1 to 8, characterised in that the second means comprise permanent magnets.

11. Magnet arrangement according to one of the claims 1 to 10, characterised in that a patient bed (22) is arranged in a manner such that it can be shifted into the first or second imaging volume (18 to 20).

## Revendications

1. Assemblage d'aimants pour un appareil de résonance magnétique de diagnostic, comportant des premiers moyens (2) destinés à produire un champ magnétique dans un premier volume (18) de formation d'image, le premier volume (18) de formation d'image étant disposé à l'intérieur des premiers moyens (2),
caractérisé en ce que
à distance des premiers moyens (2), sont disposés des seconds moyens (14) destinés à produire un champ magnétique dans un second volume (20) de formation d'image distinct du premier volume (18) de formation d'image, le second volume (20) de formation d'image étant disposé entre les premiers moyens (2) et les seconds moyens (14), et en ce que les deux moyens (2, 14) sont formés de sorte que les champs magnétiques dans les premiers et seconds volumes de formation d'image (18 ou 20), qui sont obtenus respectivement par superposition du champ magnétique produit par les premiers moyens au champ magnétique produit par les seconds moyens, sont homogènes.

2. Assemblage d'aimants suivant la revendication 1, caractérisé en ce que les premiers et seconds moyens (2 ou 14) sont disposés le long d'un axe (10).

3. Assemblage d'aimants suivant la revendication 2, caractérisé en ce que les premier et second volumes de formation d'image (18 et 20) sont disposés le long de l'axe (10).

4. Assemblage d'aimants suivant l'une des revendications 1 à 3, caractérisé en ce que les premiers et seconds moyens (2 ou 14) sont formés pour produire le champ magnétique homogène de même direction dans les deux volumes (18 et 20) de formation d'images.

5. Assemblage d'aimants suivant l'une des revendications 1 à 4, caractérisé en ce que les premiers et seconds moyens (2 ou 14) sont formés de sorte que le champ magnétique homogène produit dans les deux volumes (18 et 20) de formation d'images est dirigé parallèlement à l'axe (10).

6. Assemblage d'aimants suivant l'une des revendications 2 à 5, caractérisé en ce que les premiers moyens (2) comportent plusieurs bobines (8) d'électro-aimant montées en série et ayant des axes de bobine et en ce que les axes de bobine et l'axe (10) coincident.

7. Assemblage d'aimants suivant la revendication 6, caractérisé en ce que les bobines (8) d'électro-aimant sont formées de manière à produire respectivement un flux magnétique, le flux magnétique des bobines d'électro-aimant augmentant lorsqu'augmente la distance des bobines (8) d'électro-aimant au second volume de formation d'image.

8. Assemblage d'aimants suivant la revendication 6 ou 7, caractérisé en ce que bobines d'électro-aimant sont prévues en tant qu'aimants supra-conducteurs dans un cryostat (6).

9. Assemblage d'aimants suivant l'une des revendications 1 à 8, caractérisé en ce que les seconds moyens (14) comportent une bobine (16) d'électro-aimant.

10. Assemblage d'aimants suivant l'une des revendications 1 à 8, caractérisé en ce que les seconds moyens comportent des aimants permanents.

11. Assemblage d'aimants suivant l'une des revendications 1 à 10, caractérisé en ce qu'un lit (22) de patient est monté coulissant dans le premier ou le second volume (18 ou 20) de formation d'image.
